# EUROPEAN PATENT APPLICATION

(11) **EP 1 198 043 A2**
(43) Date of publication of application: **17.04.2002**
(21) Application number: 01123215.4
(22) Date of filing: 01.10.2001
(51) Int. Cl.: H01S 5/22, H01S 5/24, H01S 5/223, H01L 33/00, H01L 21/306

(54) **Method of fabricating a III-V compound semiconductor device with an Aluminium-compound layer**

(30) Priority: 06.10.2000 JP 2000307637
(71) Applicant: THE FURUKAWA ELECTRIC CO., LTD., Tokyo (JP)
(72) Inventor: Arakawa, Satoshi, Chiyoda-ku, Tokyo (JP); Kasukawa, Akihiko, Chiyoda-ku, Tokyo (JP)
(74) Representative: Modiano, Guido, Dr.-Ing.

(57) **Abstract**

Disclosed is a method of fabricating a compound semiconductor device, which has an Al-based compound semiconductor layer and is suitable for producing, for example, a semiconductor laser device with a buried structure. The method comprises a first step of sequentially performing vapor growth of a plurality of compound semiconductor layers including an Al-based compound semiconductor layer formed on a semiconductor substrate by using a metalorganic chemical vapor deposition (MOCVD), thereby forming a semiconductor multilayer (epitaxial layer) having, for example, a double heterostructure; a second step of selectively etching a specific compound semiconductor layer in the semiconductor multilayer other than the Al-based compound semiconductor layer in the MOCVD using a bromine-based gas, thereby forming a mesa; and a third step of regrowing a predetermined compound semiconductor layer on the semiconductor multilayer in the MOCVD following the etching step.

## Description

### BACKGROUND OF THE INVENTION

### Field of the Invention

The present invention relates to a method of fabricating a compound semiconductor device, which is suitable for reliably providing a compound semiconductor device, such as a semiconductor laser device, that has a device structure including an Al-based compound semiconductor layer and is manufactured by a fabrication process including a process of etching a semiconductor layer.

### Description of the Related Art

Ordinary semiconductor laser devices are produced using a III-V compound semiconductor which consists of at least two types of elements selected from group III elements, such as A1, In and Ga, and group V elements, such as As and P. A semiconductor laser device has a ridge type device structure that is formed by selectively etching an epitaxial layer with a DH (Double Heterostructure) grown on, a semiconductor substrate, or has a buried type device structure that has an epitaxial layer for burying a mesa after the formation of the mesa. The latter type semiconductor laser device is advantageous in the better device characteristics, i.e., the stability or the like of the threshold current and the lateral mode.

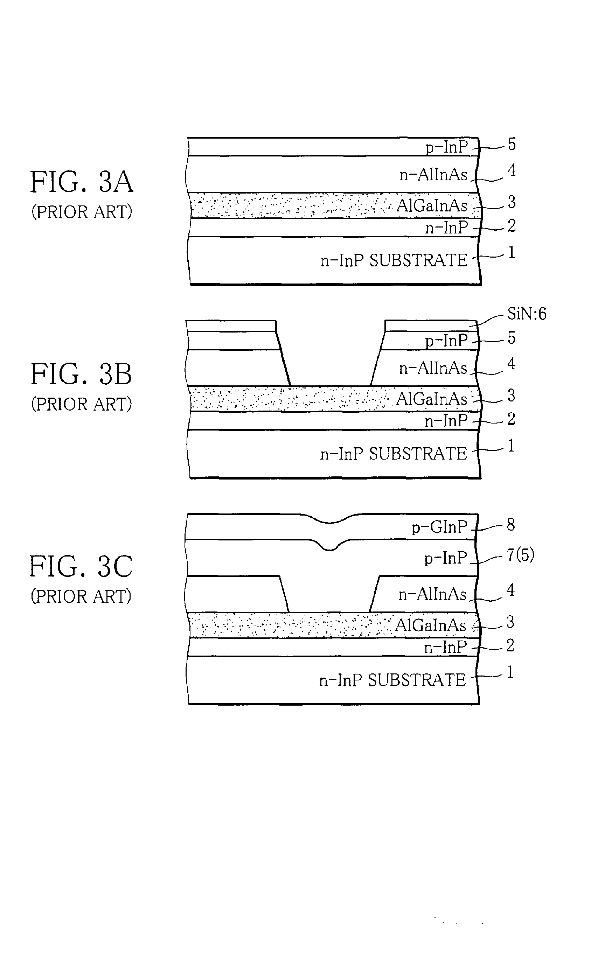

A conventional semiconductor laser device which has, for example, an AlGaInAs-based self-alignment structure (SAS) is manufactured as follows. First, as shown in Fig. 3A, an n-InP buffer layer 2 is grown on an n-InP substrate 1 by using a metalorganic chemical vapor deposition (MOCVD). Next, an active layer 3, which comprises a 100 nm-thick n-AlGaInAs (λg = 1000 nm) separate confinement hetereostructure (SCH) layer, an AlGaInAs/AlGaInAs multiquantum well (MQW) having a bandgap wavelength of, for example, 1300 nm and a well number of 6 and a 100 nm-thick p-AlGaInAs (λg = 1000 nm) SCH layer, is grown on the buffer layer 2. Then, a 500 nm-thick n-AlInAs current blocking layer 4 and a 100 nm-thick p-InP upper cladding layer 5 are sequentially grown on the active layer 3.

Next, an SiN layer 6 and a resist film (not shown) are formed on the p-InP upper cladding layer 5, and a striped window having a width of 3 µm is formed in the resist film using photolithography. With the window-formed resist film used as a mask, the SiN layer 6 is etched with a hydrofluoric acid, after which the resist film is removed. Then, as shown in Fig. 3B, the upper cladding layer 5 and the current blocking layer 4 are etched by using an etching apparatus. Then, as shown in Fig. 3C, the SiN layer 6 is removed and an p-InP upper cladding layer 7 is grown again on the entire epitaxial layer to the thickness of 2000 nm and a p-GaInAs contact layer 8 is grown on the p-InP upper cladding layer 7 by using the MOCVD.

Then, contact electrodes (not shown) are respectively formed on the top surface of the contact layer 8 and the bottom surface of the substrate 1. Next, the semiconductor substrate on which a plurality of epitaxial layers including the active layer 3 are formed is cleaved to desired sizes in a direction perpendicular to the stripe direction. This yields a semiconductor laser device of a 1300 nm-wavelength which has a self-alignment structure (SAS).

In fabricating a semiconductor laser device with such a device structure, however, the end face of the n-AlInAs current blocking layer 4 is inevitably exposed through a groove formed by etching during the fabrication process. As a result, at the time the semiconductor substrate is returned to the MOCVD after etching, the exposed n-AlInAs current blocking layer 4 is exposed to the air or an oxygen atmosphere and is oxidized. This causes a crystal defect in the subsequent crystal growth. Such a crystal defect lowers the reliability of the semiconductor laser device.

### SUMMARY OF THE INVENTION

Accordingly, it is an object of the present invention to provide a method of fabricating a compound semiconductor device, which can produce a semiconductor laser device without bringing about the aforementioned problem of oxidization of an Al-based compound semiconductor layer. The invention particularly aims at providing a method of reliably fabricating a compound semiconductor device, which has a device structure including an Al-based compound semiconductor layer and is produced by a fabrication process involving an etching process.

A method of fabricating a compound semiconductor device according to the invention comprises a first step of sequentially performing vapor growth of a plurality of compound semiconductor layers including an Al-based compound semiconductor layer formed on a semiconductor substrate by using a vapor phase growth apparatus, thereby forming a semiconductor multilayer (epitaxial layer) having, for example, a double heterostructure (DH); a second step of selectively etching a specific compound semiconductor layer in the semiconductor multilayer in the vapor phase growth apparatus using a bromine-based gas, thereby forming a mesa; and a third step of growing a predetermined compound semiconductor layer on the semiconductor multilayer by using the vapor phase growth apparatus following the etching step.

Other compound semiconductor layers besides the Al-based compound semiconductor layer in the semiconductor multilayer that is formed on the semiconductor substrate contain III-V compound semiconductors including at least two types selected from In, Ga, As and P. The selective etching of the semiconductor multilayer using a bromine-based gas is carried out using the Al-based compound semiconductor layer in the semiconductor multilayer as an etching stop layer.

The invention is suitable for providing a semiconductor laser device having a buried ridge structure or a buried heterostructure on the semiconductor substrate by selective etching of the semiconductor multilayer and subsequent vapor phase growth of a compound semiconductor layer. It is preferable to use a MOCVD as the vapor phase growth apparatus. As vapor phase growth of a compound semiconductor layer on the semiconductor substrate, an etching process of the grown compound semiconductor layer using a bromine-based gas and subsequent vapor phase growth of a compound semiconductor layer are consecutively executed in a reactor of MOCVD, the compound semiconductor device is fabricated without exposing the Al-based compound semiconductor layer to air or an oxygen atmosphere.

More specifically, in the vapor phase growth apparatus, a buffer layer of a compound semiconductor is formed on the semiconductor substrate, then an active layer including an Al-based compound semiconductor layer is formed on the buffer layer, then a cladding layer of a compound semiconductor other than an Al-based compound semiconductor is formed on the active layer. Then, the cladding layer on the active layer is selectively etched using the active layer as an etching stop layer, thereby forming a mesa, after which a compound semiconductor layer is formed to the thickness to bury the mesa.

Alternatively, in the vapor phase growth apparatus, a buffer layer of a compound semiconductor is formed on the semiconductor substrate, then an etching stop layer of an Al-based compound semiconductor is formed on the buffer layer, then an active layer and a cladding layer both of a compound semiconductor other than an Al-based compound semiconductor are sequentially formed on the etching stop layer. Then, in the vapor phase growth apparatus, the active layer and the cladding layer on the etching stop layer are selectively etched, thereby forming a mesa, after which a compound semiconductor layer is formed to the thickness to bury the mesa.

### BRIEF DESCRIPTION OF THE DRAWINGS

Fig. 1A is a diagram showing a method of fabricating a compound semiconductor device according to a first embodiment of the invention and showing a first step in the fabrication of an SAS (Self-Alignment Structure) type semiconductor laser device;
Fig. 1B is a diagram showing a second step following the step in Fig. 1A;
Fig. 1C is a diagram showing a third step following the step in Fig. 1B;
Fig. 1D is a diagram showing the schematic structure of the SAS type semiconductor laser device that is completed through a fourth step following the third step in Fig. 1C;
Fig. 1E is a diagram showing another schematic structure of the SAS type semiconductor laser device that is manufactured by the fabrication method according to the invention;
Fig. 2A is a diagram showing a method of fabricating a compound semiconductor device according to a second embodiment of the invention and showing a first step in the fabrication of a DH (Double Heterostructure) type semiconductor laser device;
Fig. 2B is a diagram showing a second step following the step in Fig. 2A;
Fig. 2C is a diagram showing a third step following the step in Fig. 2B;
Fig. 2D is a diagram showing the schematic structure of the BH type semiconductor laser device that is completed through a fourth step following the third step in Fig. 2C;
Fig. 3A is a diagram showing a first step in the fabrication of a conventional ordinary semiconductor laser device;
Fig. 3B is a diagram showing a second step following the step in Fig. 3A; and
Fig. 3C is a diagram showing the schematic structure of the semiconductor laser device that is completed through a third step following the second step in Fig. 3B.

### DETAILED DESCRIPTION OF THE INVENTION

Referring to the accompanying drawings, a description of a method of fabricating a compound semiconductor device according to the invention will be given of the case of fabricating an AlGaInAs-based semiconductor laser device.

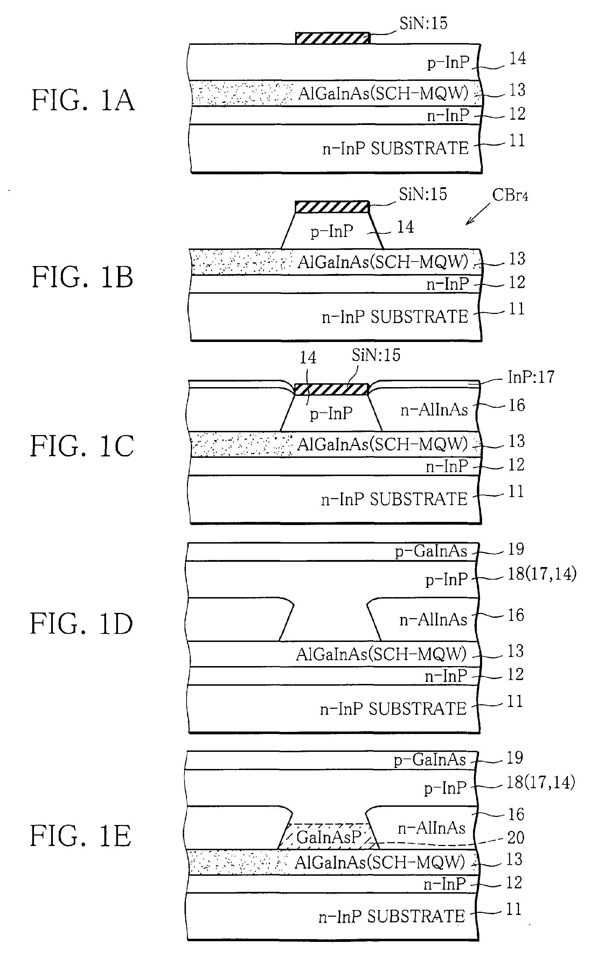

Figs. 1A through 1D illustrate a fabrication process according to the first embodiment of the invention, step by step, in the case of fabricating a compound semiconductor laser device having a self-alignment structure (SAS).

First, using a metalorganic chemical vapor deposition (MOCVD), the fabrication of this semiconductor laser device is carried out by growing an n-InP buffer layer 12 on an n-InP substrate 11, then growing an active layer 13, which comprises a 100 nm-thick n-AlGaInAs (λg = 1000 nm) SCH layer, an AlGaInAs/AlGaInAs multiquantum well having, for example, a bandgap wavelength of 1300 nm and a well number of 6 and a 100 nm-thick p-AlGaInAs (λg = 1000 nm) SCH layer, on the buffer layer 12, then growing a 300 nm-thick p-InP upper cladding layer 14 on the active layer 13, as shown in Fig. 1A (first step).

Next, an SiN layer 15 is formed on the p-InP upper cladding layer 14 and is patterned by photolithography so that the SiN layer 15 having a width of 3 µm is formed in the forward mesa direction. Then, with the SiN layer 15 used as a mask, the p-InP upper cladding layer 14 is etched in a reactor of the MOCVD with a bromine-based gas, specifically, carbon tetrabromide (CBr₄), thereby forming a mesa as shown in Fig. 1B (second step). The etching process is performed, for example, at an etching temperature of 600°C and with the CBr₄ fed at a rate of 3 µmol/min in the PH₃ atmosphere.

In the fabrication of samples by the present inventors, the p-InP upper cladding layer 14 was etched for approximately 15 minutes at an etching rate of 20 nm/min. The results showed that, as shown in Fig. 1B, a mesa without side etching and with an excellent dimension controllability with the SiN layer 15 as a mask could be formed. It was also confirmed that etching completely stopped in the depth direction on the top surface of the p-AlGaInAs (λg = 1000 nm) SCH layer and the p-AlGaInAs layer served as an etching stop layer with respect to etching of the p-InP upper cladding layer 14 by CBr₄.

Following the etching process, buried growth of a compound semiconductor layer on the epitaxial layer is performed in the reactor of the MOCVD. In the buried growth, first, an n-AlInAs current blocking layer 16 is grown to the thickness of, for example, 300 nm, then a 10 nm-thick p-InP layer 17 is grown on the n-AlInAs current blocking layer 16, as shown in Fig. 1C (third step).

The growth of the n-AlInAs current blocking layer 16 was carried out at a growth temperature of 600°C and a growth rate of 30 nm/min. It was confirmed that at the time of growing the n-AlInAs current blocking layer 16, feeding CBr₄ in the reactor of the MOCVD could suppress precipitation of a polycrystal on the SiN layer 15.

Then, the SiN layer 15 is removed using buffered hydrofluoric acid, after which in the reactor of the MOCVD,. as shown in Fig. 1D, a p-InP upper cladding layer 18 is grown to the thickness of 2000 nm and a p-GaInAs contact layer 19 is grown on the cladding layer 18 to the thickness of 300 nm. Then, contact electrodes (not shown) are respectively formed on the top surface of the contact layer 19 and the bottom surface of the substrate 11. Next, the semiconductor substrate on which the epitaxial layers having the above-described device structure are formed is cleaved to desired sizes in a direction perpendicular to the stripe direction. This yields a semiconductor laser device of a 1300 nm-wavelength range which has a buried ridge structure.

It was confirmed that the compound semiconductor laser device (compound semiconductor device) produced in the above-described manner, which basically had a device structure similar to that of the conventional semiconductor laser device shown in Fig. 3C, had its performances improved significantly in the threshold current and slope efficiency.

In short, the first embodiment of the invention comprises growing a DH epitaxial layer on the n-InP substrate 11 in the reactor of the MOCVD (first step), then selectively etching the epitaxial layer using CBr₄, thereby forming a mesa (second step), then growing the epitaxial layer for burying the mesa in the reactor (third step), thus yielding an SAS semiconductor laser device.

As the fabrication process is entirely executed in the reactor of the MOCVD although the fabrication process includes an etching process, the Al-based compound semiconductor layer that comprises the p-AlGaInAs layer in the active layer 13, which is a part of the device structure, and the n-AlInAs current blocking layer 16 is not exposed to the air or an oxygen atmosphere or the like. Accordingly, the Al-based compound semiconductor layer (the p-AlGaInAs layer and the n-AlInAs layer) is not oxidized, which would otherwise cause a crystal defect in the subsequent regrowth of the epitaxial layer. Further, as mentioned earlier, side etching hardly occurs at the time of etching the epitaxial layer (InP layer) using the bromine-based gas (CBr₄). Furthermore, as the p-AlGaInAs layer serves as an etching stop layer, a semiconductor laser device whose device structure has a high dimension precision can be realized. In this respect too, the embodiment demonstrates its impressive effect of enhancing the operational reliability of the semiconductor laser device (compound semiconductor device).

A GaInAsP layer 20 may be provided in the upper cladding layer that comprises the p-InP layer 14 in the above-described device structure as shown in Fig. 1E, so that the transverse mode of the semiconductor laser is controlled. In this case, in the first step in the above-described fabrication process, the GaInAsP layer 20 may be grown on the active layer 13 after which the p-InP upper cladding layer 14 may be grown on the GaInAsP layer 20. It was confirmed that the provision of the GaInAsP layer 20 could ensure better laser characteristics.

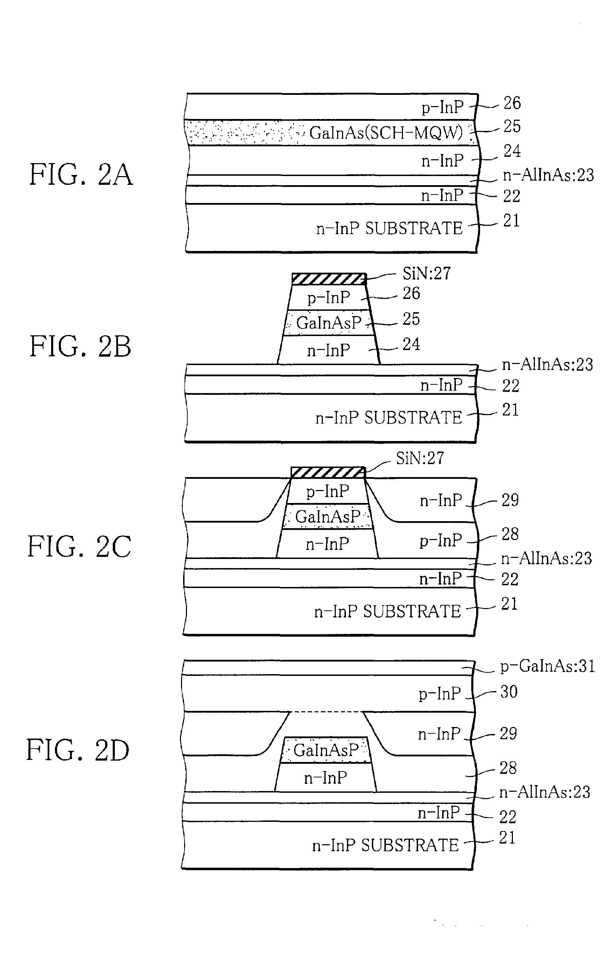

The fabrication of a BH semiconductor laser device according to a second embodiment proceeds as follows. The second embodiment will be described with reference to Figs. 2A through 2D. The fabrication of this semiconductor laser device is carried out by using an MOCVD. First, as shown in Fig. 2A, an n-InP buffer layer 22 is grown on an n-InP substrate 21, then an n-AlInAs etching stop layer 23 is formed 10 nm-thick on the buffer layer 22. Next, an n-InP under cladding layer 24 having a thickness of 300 nm is grown on the etching stop layer 23, then a GaInAsP-based. active layer 25, which comprises a 100 nm-thick n-GaInAsP (λg = 1100 nm) SCH layer, a GaInAsP/GaInAsP multiquantum well having, for example, a bandgap wavelength of 1300 nm and a well number of 6 and a 100 nm-thick p-GaInAsP (λg = 1100 nm) SCH layer, is grown on the n-InP under cladding layer 24. Then, a 200 nm-thick p-InP upper cladding layer 26 is grown on the active layer 25 (first step).

Next, an SiN layer 27 having a width of, for example, 2 µm, is formed on the p-InP upper cladding layer 26 in the backward mesa direction. With the SiN layer 27 used as a mask, the p-InP upper cladding layer 26, the GaInAsP-based active layer 25 and the n-InP under cladding layer 24 are sequentially etched in the reactor of the MOCVD using CBr₄, thereby forming a mesa as shown in Fig. 2B (second step). The etching process is performed, for example, at an etching temperature of 600°C and with the CBr₄ fed at a rate of 3 µmol/min in the PH₃ atmosphere.

The etching rate in this case is 20 nm/min for the InP layers 26 and 24, and is 10 nm/min for the GaInAsP-based active layer 25. In the second embodiment, etching was carried out for approximately 60 minutes. The results showed that, as shown in Fig. 2B, a mesa without side etching and with an excellent dimension controllability with the SiN resist film 27 as a mask could be formed. It was also confirmed that etching completely stopped in the depth direction on the top surface of the n-AlInAs etching stop layer 23 and the n-AlInAs etching stop layer 23 served as an etching stop layer with respect to the etching of the p-InP and GaInAsP-based semiconductor layers by CBr₄.

Following the etching process, buried growth of a compound semiconductor layer on the epitaxial layer is performed in the reactor of the MOCVD. In the buried growth, first, a p-InP layer 28 is grown to the thickness of, for example, 300 nm, then an n-InP layer 29 is grown 200 nm-thick on the p-InP layer 28, as shown in Fig. 2C (third step).

The growth of the InP layers 28 and 29 was performed at a growth temperature of 600°C and a growth rate of 60 nm/min.

Then, the SiN layer 27 is removed using buffered hydrofluoric acid, after which in the reactor of the MOCVD, as shown in Fig. 2D, a p-InP upper cladding layer 30 is grown to the thickness of 2000 nm and a p-GaInAs contact layer 31 is grown on the upper cladding layer 30 to the thickness of 300 nm. Then, contact electrodes (not shown) are respectively formed on the top surface of the contact layer 19 and the bottom surface of the substrate 11. Next, the semiconductor substrate on which the epitaxial layers having the above-described device structure are formed is cleaved to desired sizes in a direction perpendicular to the stripe direction. This yields a semiconductor laser device of a 1300-nm wavelength range.

In the above-described fabrication of the semiconductor laser device of the second embodiment, as per the first embodiment, the epitaxial growth of a compound semiconductor layer on the semiconductor substrate 21, the selective etching of the epitaxial layer and the subsequent regrowth of a compound semiconductor layer are all executed in the reactor of the MOCVD. Therefore, the GaInAsP-based active layer 25 whose oxidation should be avoided will not be exposed to the air or an oxygen atmosphere. It is thus possible to easily fabricate a semiconductor laser device (compound semiconductor device) that has a device structure of high dimension precision and an excellent crystalline characteristic and demonstrate a highly reliable operation.

The invention is not limited to those two embodiments. Although prevention of oxidation of the GaInAsP layer or the AlGaInAs layer that is grown on the InP substrate is discussed in the foregoing description of the embodiments, the invention can also be adapted to the case where an AlGaAs-based or AlGaInP-based compound semiconductor layer is grown on a GaAs substrate. That is, the invention can effectively be adapted to the case of fabricating a semiconductor device that is constructed to have a lamination of a III-V compound semiconductor which contains at least two kinds selected from In, Ga, As and P and an Al-based compound semiconductor.

The invention is applicable not only to the fabrication of a semiconductor laser device that involves an etching process for forming a mesa and the subsequent epitaxial growth, but also to the fabrication of a compound semiconductor device that involves an etching process for forming a butt-joint and the subsequent epitaxial growth. Further, the above-described etching process is applicable to the case of using a bromine-based gas other than CBr₄, such as CH₃Br, as an etching gas. The invention may be modified in other forms without departing from the spirit or scope of the invention.

According to the present invention, as described above, as etching of an epitaxial layer is carried out using a bromine-based gas in a vapor phase growth apparatus, it is possible to consecutively execute the growth of a compound semiconductor layer, the mentioned etching process, and the subsequent regrowth of a compound semiconductor layer. Even in the case of fabricating a compound semiconductor device whose structure includes an Al-based compound semiconductor layer whose oxidation should be avoided, therefore, oxidation-originated crystal defects and side etching will not occur. This makes it possible to control the dimension at a high accuracy and thus easily fabricate a highly reliable compound semiconductor device which has an excellent crystalline characteristic.

As etching is performed while using the Al-based compound semiconductor layer as an etching stop layer to stop etching by a bromine-based gas, the invention also demonstrate an effect of sufficiently enhancing the etching control precision for epitaxial layers.

Where technical features mentioned in any claim are followed by reference signs, those reference signs have been included for the sole purpose of increasing the intelligibility of the claims and accordingly, such reference signs do not have any limiting effect on the scope of each element identified by way of example by such reference signs.

## Claims

1. A method of fabricating a compound semiconductor device, comprising steps of:
selectively etching with a bromine-based gas in a vapor phase growth apparatus a specific compound semiconductor layer, said specific compound semiconductor layer being a layer of a semiconductor multilayer structure, said semiconductor multilayer structure including an Al-based compound semiconductor layer as part of a plurality of semiconductor layers formed on a semiconductor substrate; and
growing in said vapor phase growth apparatus a predetermined compound semiconductor layer on said semiconductor multilayer structure, following said etching step.

2. The method of Claim 1, wherein:
except for said Al-based compound semiconductor layer, said plurality of semiconductor layers containing III-V compounds including at least two of In, Ga, As, and P.

3. The method of Claim 1, wherein:
said selective etching step includes limiting an etch depth with said Al-based compound semiconductor layer serving as an etch stop.

4. The method of Claim 1, wherein:
said growing step comprises growing the predetermined compound semiconductor layer so as to form at least one of a buried ridge structure and a buried heterostructure structure on said substrate as part of a semiconductor laser device.

5. The method of Claim 1, wherein:
said growing step includes growing said predetermined compound semiconductor layer by MOCVD.

6. The method of Claim 1, wherein:
said semiconductor substrate including at least one of an InP material and a GaAs material.

7. A method of fabricating a compound semiconductor device, comprising steps of:
sequentially growing via vapor growth in a vapor phase growth apparatus a plurality of compound semiconductor layers so as to form a semiconductor multilayer structure, said semiconductor multilayer structure including
an Al-based compound semiconductor layer, and
a predetermined compound semiconductor layer;
forming a mesa by selectively etching using a bromine-based gas in said vapor phase growth apparatus, except for said Al-based compound semiconductor layer, the predetermined compound semiconductor layer; and
regrowing at least a portion of the predetermined compound semiconductor layer on said semiconductor multilayer in said vapor phase growth apparatus following said forming a mesa step.

8. The method of Claim 7, wherein:
said sequentially growing step includes
forming a buffer layer of a compound semiconductor layer on said semiconductor substrate,
forming an active layer including the Al-based compound semiconductor layer on said buffer layer, and
forming a cladding layer of a compound semiconductor layer other than said Al-based compound semiconductor on said active layer; and
said selectively etching step includes etching said cladding layer on said active layer using said active layer as an etch stop.

9. The method of Claim 7, wherein:
said sequentially performing step includes forming a buffer layer of a compound semiconductor material on said semiconductor substrate,
forming an etch stop of an Al-based compound semiconductor material on said buffer layer,
sequentially forming an active layer and a cladding layer both of a compound semiconductor material other than an Al-based compound semiconductor material used on said etch stop; and
said selectively etching step includes selectively etching said active layer and said cladding layer on said etch stop.

10. The method of Claim 7, wherein:
said compound semiconductor device being a semiconductor laser.

11. The method of Claim 7, wherein:
said semiconductor substrate including at least one of an InP material and a GaAs material.

12. A method of fabricating a compound semiconductor device, comprising steps for:
selectively forming by etching a specific compound semiconductor layer, said specific compound semiconductor layer being a layer of a semiconductor multilayer structure, said semiconductor multilayer structure including an Al-based compound semiconductor layer as part of a plurality of semiconductor layers formed on a semiconductor substrate, said selectively forming step includes a substep for
forming said Al-based compound semiconductor layer without exposing an abutting surface of said Al-based compound semiconductor layer to air or oxygen so as to prevent said abutting surface from becoming oxidized; and
growing in said vapor phase growth apparatus a predetermined compound semiconductor layer on said semiconductor multilayer structure so as to abut and cover said abutting surface of said Al-based compound semiconductor layer.

13. The method of Claim 12, wherein:
except for said Al-based compound semiconductor layer, said plurality of semiconductor layers containing III-V compounds including at least two of In, Ga, As, and P.

14. The method of Claim 12, wherein:
said selectively forming by etching step includes limiting an etch depth with said Al-based compound semiconductor layer serving as an etch stop.

15. The method of Claim 12, wherein:
said growing step comprises growing the predetermined compound semiconductor layer so as to form at least one of a buried ridge structure and a buried heterostructure structure on said substrate as part of a semiconductor laser device.

16. The method of Claim 12, wherein:
said growing step includes growing said predetermined compound semiconductor layer by MOCVD.

17. The method of Claim 12, wherein:
said semiconductor substrate including at least one of an InP material and a GaAs material.
